# EUROPEAN PATENT SPECIFICATION

(11) **EP 0 778 804 B1**
(45) Date of publication and mention of the grant of the patent: **28.08.2002**
(21) Application number: 95933195.0
(22) Date of filing: 22.09.1995
(51) Int. Cl.: B60J 1/00, C08F 4/00, C09J 4/00, G03F 1/14

(54) **OPTICAL PELLICLE MEMBRANE TO FRAME ADHESION METHOD**
VERFAHREN ZUR VERKLEBUNG EINER OPTISCHEN MEMBRANADDECKUNG FÜR RAHMEN
PROCEDE DE COLLAGE D'UNE MEMBRANE DE PELLICULE OPTIQUE SUR UN CADRE

(30) Priority: 22.09.1994 US 310535
(43) Date of publication of application: 18.06.1997
(73) Proprietor: MICRO LITHOGRAPHY, INC., Sunnyvale, CA 94089 (US)
(72) Inventor: WANG, Ching-Bore, Fremont, CA 94536 (US); YEN, Ysung-Tsai, Atherton, CA 94025 (US)
(74) Representative: Thomson, Paul Anthony
(86) International application number: US9512079
(87) International publication number: WO96009183

(56) References cited:
- US-A- 4 985 473
- US-A- 5 168 001

## Description

### Background of the Invention

This invention relates to adhesives used with optical elements, and more particularly to a 100%-solids adhesive emulsion for mounting an optical pellicle to a frame.

In recent years, various optical elements, such as pellicles, lenses, and the like have played an important role in the fabrication of semiconductor wafers used in integrated semiconductor circuits. As is well understood by those skilled in the art, optical pellicles provide anti-contamination protection for photomasks which are used in the various photolithography steps required in wafer fabrication.

A typical optical pellicle takes the form of an extremely thin optical film which is supported on a ring-like frame, the entirety of which is then placed over a photoresist-coated wafer during photolithography. To be most effective, a pellicle, in addition to preventing contamination of a photomask, should exhibit a very high degree of optical transmissivity at the wavelengths of light which are used during photolithography.

While single-layer pellicles, typically fabricated of nitrocellulose or cellulose acetate, have been widely successfully used in the past, there are many instances in which the user desires an even higher degree of transmissivity than is obtainable with such a pellicle. To this end, the preparation of plural-layer pellicles which include anti-reflective coatings have been utilized. One such coating system is disclosed in U.S. Pat. No. 4,759,990 entitled Composite Optical Element Including Anti-reflective Coating. This patent discloses a plural-layer optical pellicle including a base layer, an organic intermediate layer, and an outer fluorocarbon coating which is applied over the face of the intermediate layer.

The use of anti-reflective (AR-) coatings on pellicle membranes has caused certain problems relating to ineffective adherence of the membrane to the pellicle frame. Conventional pellicle adhesives and associated mounting methods have been ineffective to provide the necessary bond between the coated pellicle membrane and frame.

In the telecommunications field, similar problems have been encountered with respect to adhering fluoropolymer-coated optical fibers together.

One conventional proposal for pellicle applications, European Pat. No. 0235428 entitled Mounting Preparation for Optical Membrane, involves removal of the AR-coating from the portion of the pellicle membrane which will be adhered to the pellicle frame. Thus, the nitrocellulose, cellulose-acetate or other base layer will then be directly applied to the pellicle membrane.

The partial removal of the AR-coating necessitates an additional step in the fabrication process, and also has the drawback of presenting a membrane surface from which one layer has been partially removed. Such a surface can be a source for additional, unwanted particulate generated from during the removal process. Such particulate, while microscopic in size, poses a serious problem, because pellicles function to prevent particulate from dropping on photomasks. Unless such particulate is removed from the photomask, it could be reproduced in the wafer into which the integrated circuit is being etched. This is particularly true where shorter wavelength, so-called deep UV light is used. Such light, in wavelengths of 248 and 193 nanometers (nm), is used to increase the number of integrated-circuit components which can be etched into a given wafer area.

There have also been attempts to address the problem of adhesion of AR- coatings to pellicle frames. One such attempt is disclosed in European Patent No. 488788A1 to Fujita et al. entitled Pellicle Structure and Process for Preparation Thereof. That patent discusses the use of a solvent-based adhesive system with a thermoset acrylic resin, tetrahydrofurfuryl acrylate or phenoxyethyl acrylate, and a solvent such as an aromatic one. Fujita et al. states that the adhesive system is used to bond the frame and AR-coated pellicle membrane without requiring prior removal of the AR-coating layer, and without the danger of generating microscopic particulate.

A problem with using the Fujita et al. proposal is that the membrane is still not adequately bonded to the pellicle frame, and so the pellicle system has a shorter life than is desirable. That is, the bond between the membrane and the frame will break down over time, or the bond will break when the membrane is subjected to air-blow cleaning operations which are sometimes utilized prior to mounting the pellicle to the photomask.

Another problem with the Fujita et al. proposal is that it is a solvent-based system which is undesirable from a manufacturing and safety standpoint.

It is accordingly an object of the present invention to provide a pellicle membrane adhesive system which overcomes the drawbacks and limitations of the prior art proposals. More specifically, the invention has as its objects the following: 1) to develop a system for securely bonding an AR-coated optical element to a frame; 2) to provide a pellicle mounting system for a coated pellicle membrane which minimizes the likelihood of generating particulate; 3) to develop a system for adhering an AR-coated optical pellicle to a frame which does not require an intermediate step of removing a portion of the AR-coating; and 4) to provide an adhesive for bonding an AR-coated optical membrane to a frame without deleteriously affecting the stability/durability of the overall pellicle system.

According to the present invention there is provided a 100%-solids adhesive emulsion for adhering together plural fluoropolymer-coated articles, comprising:
a first component including a mercapto-ester polymer and an acrylate monomer that is curable according to a free radical curing mechanism;
a second component including a fluorocarbon compounds;
a surfactant; and
an initiator;
with the components being emulsifiable into an adhesive emulsion that includes an effective amount of initiator, between 0.1% and 5% by volume surfactant, between 2% and 40% by volume of the second component, and the remainder being the first component;
and wherein the adhesive emulsion is effective to adhere together plural fluoropolymer-coated articles.

The first component includes a mercapto-ester polymeric resin and an acrylate monomeric resin. Examples of the first component include a resin marketed under the trademark Norland Optical Adhesive 65, and a resin marketed under the trademark Master Bond Polymer System UV15-7.

Preferably, the second component includes a fluorocarbon compound containing an acrylate functional group. A fluorinated acrylate monomer would be even more preferable. Pentadecafluorooctylacrylate or octafluoropentylacrylate may be used as the second component.

Another aspect of the invention includes a method for adhering an optical pellicle membrane to a pellicle frame with plural upper planar surfaces. The method comprises applying a coat of the adhesive emulsion of the invention to at least one of the upper planar surfaces of the pellicle frame adjacent the outer edge of an underside of the pellicle membrane, pressing the surface of the frame to the underside of the pellicle membrane and curing the frame-mounted membrane to cure the adhesive emulsion.

Preferably, the method of the invention also includes the step of permitting the frame-mounted membrane to sit for a predetermined period of time before performing the curing step. Also, the curing step may be accomplished by an appropriate curing mechanism, such as light/photo curing or heat curing.

Yet another aspect of the invention includes a pellicle system for use in photolithography, which system includes a pellicle frame with an upper surface, and a pellicle membrane with a bottom surface that includes an outer region. The membrane is positionable over the frame so that the outer region is contactable with the upper surface of the frame. An adhesive emulsion in accordance with the invention, interposes the outer region of the membrane and the upper surface of the frame, and such adhesive emulsion is curable ultimately to attach the outer region of the membrane to the upper surface of the frame.

While this summary of the invention describes use of the adhesive with an optical pellicle system, the invention is equally applicable to other AR-coated optical elements whether or not mounted to a frame.

Other objects and features of the present invention will become more apparent as this description continues.

### Brief Description of the Drawings

Fig. 1 is a schematic side elevation sectional view of a prior art system, exaggerated to show the location of a portion of the anti-reflective coating that had been removed.

Fig. 2 is a side elevation sectional view showing a coated optical membrane
being placed over a pellicle frame as it would be when using the adhesive emulsion of the present invention.

Fig. 3 is like Fig. 2 only it depicts a pellicle system with a membrane having been mounted to the pellicle frame by adhering it to the same using the adhesive emulsion of the present invention.

### Detailed Description of the Preferred Embodiments

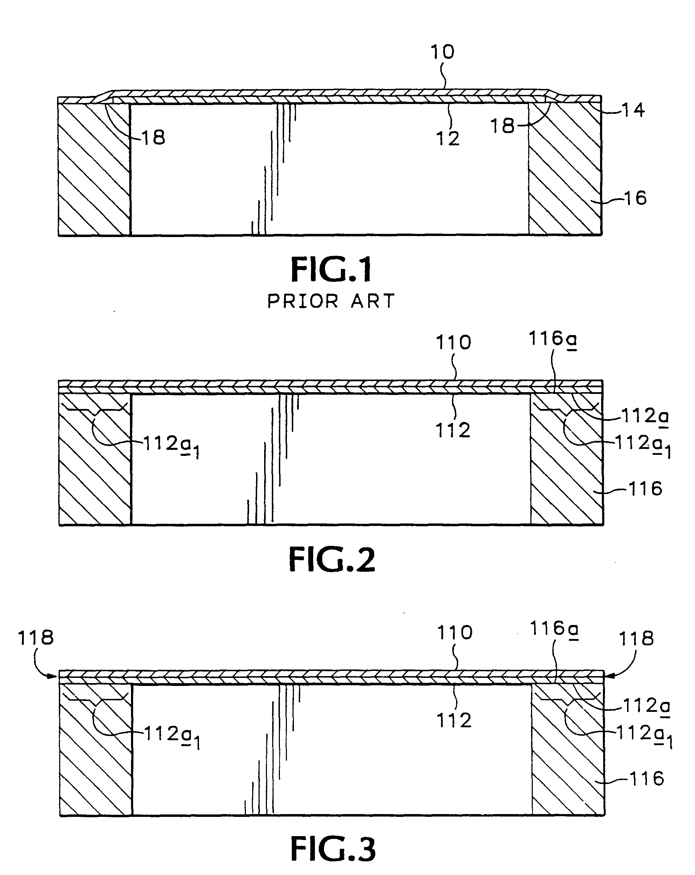

As described above, the preferred embodiments of the present invention involve a 100%-solids adhesive emulsion which is primarily usable to mount an AR-coated pellicle membrane to its frame. However, the adhesive emulsion of the present invention is effective to adhere together plural fluoropolymer-coated articles of any kind including, for example, plural fluoropolymer-coated optical fibers. Fig. 1 depicts a prior art system with a pellicle membrane 10 being coated with at least one anti-reflective (AR-) coating 12, with a section of the AR-coating having previously been removed at an interface 14 between the coated pellicle membrane and a pellicle frame 16. Not only does this conventional system require the additional step of removing a section of the AR-coating layer, but it also presents the possibility of particulate or debris being generated from, for example, the outer peripheral area of the AR-coating, shown schematically at 18.

Still referring to Fig. 1, the viewer will recognize that the section of the pellicle membrane which remains after removal of the AR-coating is the section that is bonded to the pellicle frame. That section is thinner than the entire coated membrane, and may be damaged or weakened during the AR-coating removal step. There is the possibility that membrane 10 may not be adequately bonded to the pellicle frame 16. It is also necessary to perform the extra step of removing a portion of the AR-coating, thereby necessarily increasing the fabrication cost of a pellicle system manufactured according to this method.

Fig. 2 schematically depicts an optical membrane 110 with an AR-coating layer 112 applied to a bottom surface 112a of the membrane. The coated membrane is to be mounted to a pellicle frame 116 at an upper surface 116a of the frame. Membrane 110 is positionable over frame 116 so that an outer region 112a₁ is contactable with upper surface 116a of the frame.

Fig. 3 is like Fig. 2 only that the adhesive emulsion of the present invention has been applied to upper surface 116a of the frame and a new adhesive layer 118 has replaced the AR-coating layer at the outer regions 112a₁. That new layer is formed because the adhesive emulsion of the present invention reacts with the AR-coating layer to form a chemical compound 118 that provides a stable bond between the coated membrane and the frame. When the adhesive emulsion of the present invention is applied to upper surface 116a, it interposes the outer region of the membrane and the upper surface of the frame, and is curable, as will be described, ultimately to attach the outer region of the membrane to the upper surface of the frame.

By using the adhesive emulsion of the present invention, the extra, conventional AR-coating-removal step is eliminated.

The adhesive emulsion of the present invention is a 100%-solids adhesive emulsion for use in mounting an optical pellicle to its frame. It includes (1) a first component including a resin that is curable according to a free radical curing mechanism, (2) a second component including a fluorocarbon compound, (3) a surfactant, and (4) an initiator. The components are emulsifiable, using to-be-described equipment, into an adhesive emulsion that includes an effective amount of initiator, between about 0.1% and 5% by volume surfactant, between about 2% and 40% of the second component, and the remainder being the first component.

The first component preferably includes a mercapto-ester polymeric resin and an acrylate monomeric resin. Examples of the first component include a resin marketed under the trademark Norland Optical Adhesive 65, and a resin marketed under the trademark Master Bond Polymer System UV15-7.

The second component preferably includes a fluorocarbon compound containing an acrylate functional group, such as a fluorinated acrylate monomer. The preferred chemical structure is as follows: 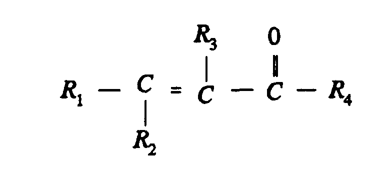 where there is at least one fluorine atom in R₁, R₂, R₃ or R₄, R₃ contains up to 10 carbon atoms, and R₄ contains greater than 5 carbon atoms.

Examples of the second component include pentadecafluorooctylacrylate or octafluoropentylacrylate.

The surfactant is preferably fluorinated, taking the form of a fluoroaliphatic polymeric ester, such as those available commercially under the trademarks FLUORAD FC-431 or FLUORAD FC-430.

The adhesive emulsion of the present invention also includes an appropriate initiator, such as a peroxide.

The components of the adhesive emulsion are emulsified, normally using a mechanical mixer, homogenizer or blender. The preferred homogenizer is sold under the trademark Tissue Tearer, model no. 985-370, marketed by Biospec Products, Inc.

The emulsion is prepared blending approximately 20 to 50 ml of the above mixture at room temperature for between about 1 to 10 minutes. The resulting adhesive emulsion is relatively stable, with a shelf life of about two days. For shelf periods greater than two days, the adhesive emulsion should be remixed as above to renew the emulsion. To use the adhesive emulsion to mount the pellicle to its frame, the adhesive is normally applied to upper surface 116a of the pellicle frame. Alternatively, the adhesive emulsion could be applied to the underside of the pellicle membrane, or to both the membrane and the frame. When the emulsion is applied to the frame, it is normally sprayed on using an automated pressurized syringe dispenser. When a 120 X 98 mm outer diameter, 2 mm wide rectangular pellicle is utilized, approximately 7 to 8 mg of adhesive emulsion is used. This results in a relatively uniform application of adhesive emulsion along the upper surface of the pellicle frame.

The following procedure is used to mount the pellicle membrane on the frame and cure the adhesive emulsion. First, the membrane is mounted to the pellicle frame by laying it over and weighing it down for a period of a few minutes. It is permitted to sit for at least approximately 1 minute prior to application of UV light. Apparently this delay permits the adhesive emulsion of the present invention to react fully with the AR coating and replace it with a new compound as shown at 118 of Fig. 3. After the setting period of a few minutes, and while the membrane is still being weighted down, the adhesive emulsion is then cured by being subjected to UV light for a period of from about 1 to 5 minutes. The UV-light source typically used is a 300-watt medium pressure mercury lamp, which is spaced approximately 8 inches from the membrane. After curing, the membrane is trimmed around the outside of the frame, and it is packaged for use.

In the method aspect of the present invention, the method involves using the above-described adhesive emulsion. A selecting step includes selecting a first component including a resin that is curable according to a free radical curing mechanism, a second component including a fluorocarbon compound, a surfactant, and an initiator. A forming step includes forming an adhesive emulsion by mixing together the resin component, the monomer component, the surfactant and the initiator, at a predetermined mix ratio, such as the one described above. An applying step includes applying a coat of the adhesive emulsion to at least one of upper planar surfaces 116a of pellicle frame 116 adjacent the outer region 112a of the AR-coating layer. A pressing step includes pressing the surface of the frame to the underside of the pellicle membrane, and a curing step includes curing the frame-mounted membrane to cure the adhesive emulsion.

Preferably, the selecting step includes selecting a first component that includes a mercapto-ester polymeric resin and an acrylate monomeric resin, and selecting a second component that includes a chemical compound with the following chemical structure: 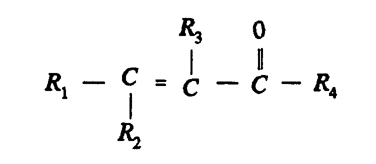 wherein there is at least one fluorine atom in R₁, R₂, R₃ or R₄, R₃ contains up to 10 carbon atoms, and R₄ contains greater than 5 carbon atoms.

The method also preferably includes the step of permitting the frame-mounted membrane 110 to sit for a predetermined time period of at least 1-minute and preferably between 1- to 3-minutes before performing the curing step.

In the pellicle system aspect of the present invention, there is a pellicle system for use in photolithography which includes a pellicle frame 116 having an upper surface 116a, a pellicle membrane 110 with an AR-coating layer 112 applied to its bottom surface 110a. An outer region 112a of AR-coating layer 112 is positionable over the frame so that the outer region is contactable with the upper surface of the frame. If the pellicle is uncoated, then an outer region of bottom surface 110a is positionable over the frame so that the outer region is contactable with the upper surface of the frame. An adhesive emulsion interposes the outer region of the membrane and the upper surface of the frame, with the adhesive emulsion being curable ultimately to attach the outer region of the membrane to the upper surface of the frame.

The invention achieves its objects by providing an adhesive emulsion for securely bonding an AR-coated optical element to a frame, and by providing a pellicle mounting system for a coated pellicle membrane which minimizes the likelihood of generating particulate. The invention also provides an adhesive emulsion for adhering an AR-coated optical pellicle to a frame which does not require an intermediate step of removing a portion of the AR- coating, and provides an adhesive emulsion for bonding an AR-coated optical membrane to a frame without deleteriously affecting the stability/durability of the overall pellicle system.

It should now be understood that the adhesive emulsion of the present invention could also be used in the telecommunications field to adhere fluoropolymer-coated optical fibers together.

Accordingly, while a preferred embodiment of the invention has been described herein, it is appreciated that modifications are possible that are within the scope of the invention.

## Claims

1. A 100%-solids adhesive emulsion for adhering together plural fluoropolymer-coated articles, comprising:
a first component including a mercapto-ester polymer and an acrylate monomer that is curable according to a free radical curing mechanism;
a second component including a fluorocarbon compounds;
a surfactant; and
an initiator;
with the components being emulsifiable into an adhesive emulsion that includes an effective amount of initiator, between 0.1% and 5% by volume surfactant, between 2% and 40% by volume of the second component, and the remainder being the first component;
and wherein the adhesive emulsion is effective to adhere together plural fluoropolymer-coated articles.

2. An adhesive emulsion of claim 1, wherein the second component includes a fluorocarbon compound containing an acrylate functional group.

3. An adhesive emulsion of claim 2, wherein the second component includes a fluorinated acrylate monomer.

4. An adhesive emulsion of claim 3, wherein the second component has the following chemical structure: 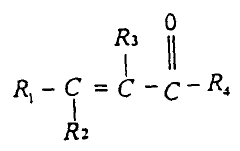 wherein there is at least one fluorine atom in R₁, R₂, R₃ or R₄, R₃ contains up to 10 carbon atoms, and R₄ contains greater than 5 carbon atoms.

5. An adhesive emulsion of claim 4, wherein the second component includes a chemical compound chosen from the group consisting of pentadecafluorooctylacrylate or octafluoropentylacrylate.

6. An adhesive emulsion of any preceding claim, wherein the surfactant is fluorinated.

7. An adhesive emulsion of claim 6, wherein the surfactant includes a fluoroaliphatic polymeric ester.

8. A method for adhering an optical pellicle membrane to a pellicle frame with plural upper planar surfaces, comprising applying a coat of the adhesive emulsion as claimed in any one of claims 1 to 7 to at least one of the upper planar surfaces of the pellicle frame adjacent the outer edge of an underside of the pellicle membrane, pressing the surface of the frame to the underside of the pellicle membrane and curing the frame-mounted membrane to cure the adhesive emulsion.

9. A method of claim 8, further including the step of permitting the frame-mounted membrane to sit for a predetermined period of time before performing the curing step.

10. A pellicle system for use in photolithography, which system includes a pellicle frame with an upper surface and a pellicle membrane with a bottom surface that includes an outer region, the membrane being positionable over the frame so that the outer region is contactable with the upper surface of the frame, an adhesive emulsion of any one of claims 1 to 7 interposing the outer region of the membrane and the upper surface of the frame, and such adhesive emulsion being curable ultimately to attach the outer region of the membrane to the upper surface of the frame.

## Patentansprüche

1. 100 %-Feststoff-Klebstoffemulsion zum Zusammenkleben von mehreren mit Fluorpolymer beschichteten Gegenständen, umfassend:
eine erste Komponente, einschließend ein Mercaptoesterpolymer und ein Acrylatmonomer, das gemäß einem freiradikalischen Aushärtemechanismus aushärtbar ist,
eine zweite Komponente, einschließend eine Fluorkohlenstoffverbindung,
eine oberflächenaktive Substanz und
einen Initiator,
wobei die Komponenten zu einer Klebstoffemulsion emulgierbar sind, die eine wirksame Menge an Initiator, zwischen 0,1 Vol.% und 5 Vol.% oberflächenaktive Substanz, zwischen 2 Vol.% und 40 Vol.% der zweiten Komponente umfaßt, und der Rest die erste Komponente ist,
und wobei die Klebstoffemulsion wirksam ist, um mehrere mit Fluorpolymer beschichtete Gegenstände zusammenzukleben.

2. Klebstoffemulsion nach Anspruch 1, worin die zweite Komponente eine Fluorkohlenstoffverbindung einschließt, die eine funktionelle Acrylatgruppe enthält.

3. Klebstoffemulsion nach Anspruch 2, worin die zweite Komponente ein fluoriertes Acrylatmonomer enthält.

4. Klebstoffemulsion nach Anspruch 3, worin die zweite Komponente die folgende chemische Struktur aufweist: 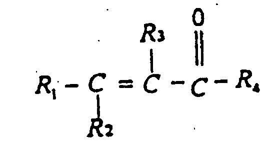 worin in R₁, R₂, R₃ oder R₄ mindestens ein Fluoratom enthalten ist, R₃ bis zu 10 Kohlenstoffatome enthält und R₄ mehr als 5 Kohlenstoffatome enthält.

5. Klebstoffemulsion nach Anspruch 4, worin die zweite Komponente eine chemische Verbindung einschließt, die aus der Gruppe ausgewählt ist, die aus Pentadecafluoroctylacrylat oder Octafluorpentylacrylat besteht.

6. Klebstoffemulsion nach einem vorstehenden Anspruch, worin die oberflächenaktive Substanz fluoriert ist.

7. Klebstoffemulsion nach Anspruch 6, worin die oberflächenaktive Substanz einen fluoraliphatischen polymeren Ester einschließt.

8. Verfahren zum Kleben einer optischen Häutchenmembran auf einen Häutchenrahmen mit mehreren oberen ebenen Oberflächen, umfassend das Aufbringen eines Films der Klebstoffemulsion nach einem der Ansprüche 1 bis 7 auf mindestens eine der oberen ebenen Oberflächen des Häutchenrahmens, die an die Außenkante einer Unterseite der Häutchenmembran angrenzt, indem die Oberfläche des Rahmens gegen die Unterseite der Häutchenmembran gepreßt wird und die auf dem Rahmen angebrachte Membran ausgehärtet wird, um die Klebstoffemulsion auszuhärten.

9. Verfahren nach Anspruch 8, weiterhin einschließend den Schritt des Sitzenlassens der auf dem Rahmen angebrachten Membran für einen vorbestimmten Zeitraum, bevor der Aushärteschritt durchgeführt wird.

10. Häutchensystem zur Verwendung in der Photolithographie, das einen Häutchenrahmen mit einer oberen Oberfläche und eine Häutchenmembran mit einer unteren Oberfläche einschließt, die einen äußeren Bereich einschließt, wobei die Membran so über dem Rahmen positionierbar ist, daß der äußere Bereich mit der oberen Oberfläche des Rahmens in Berührung kommen kann, wobei eine Klebstoffemulsion nach einem der Ansprüche 1 bis 7 zwischen dem äußeren Bereich der Membran und der oberen Oberfläche des Rahmens liegt, und eine derartige Klebstoffemulsion letzten Endes aushärtbar ist, um den äußeren Bereich der Membran an der oberen Oberfläche des Rahmens zu befestigen.

## Revendications

1. Émulsion adhésive de matières solides à 100 % destinée à coller ensemble une pluralité d'articles enduits de fluoropolymère, comprenant :
un premier composant comprenant un polymère mercapto-ester et un monomère acrylate qui est polymérisable selon un mécanisme de polymérisation radicalaire ;
un second composant comprenant un composé fluorocarboné ;
un tensio-actif ; et
un initiateur ;
lesdits composants étant émulsionnables en émulsion adhésive qui comprend une quantité efficace d'initiateur, entre 0,1 % et 5 % en volume de tensio-actif, entre 2 % et 40 % en volume du second composant, et le reste étant le premier composant ;
et dans laquelle l'émulsion adhésive est efficace pour coller ensemble une pluralité d'objets enduits de fluoropolymère.

2. Émulsion adhésive selon la Revendication 1, dans laquelle le second composant comprend un composé fluorocarboné contenant un groupe fonctionnel acrylate.

3. Émulsion adhésive selon la Revendication 2, dans laquelle le second composant comprend un monomère acrylate fluoré.

4. Émulsion adhésive selon la Revendication 3, dans laquelle le second composant possède la structure chimique suivante : 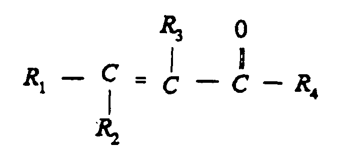 dans laquelle il y a au moins un atome de fluor en R₁, R₂, R₃ ou R₄, R₃ contient jusqu'à 10 atomes de carbone, et R₄ contient plus de 5 atomes de carbone.

5. Émulsion adhésive selon la Revendication 4, dans laquelle le second composant comprend un composé chimique choisi dans le groupe se composant du pentadécafluoro-octylacrylate ou de l'octafluoropentylacrylate.

6. Émulsion adhésive selon l'une quelconque des Revendications précédentes, dans laquelle le tensio-actif est fluoré.

7. Émulsion adhésive selon la Revendication 6, dans laquelle le tensio-actif comprend un ester polymère fluoroaliphatique.

8. Procédé de collage d'une membrane de pellicule optique sur un cadre de pellicule avec une pluralité de surfaces planes supérieures, comprenant l'application d'une couche de l'émulsion adhésive selon l'une quelconque des Revendications 1 à 7 sur au moins une des surfaces planes supérieures du cadre de pellicule de manière adjacente au bord externe d'une surface inférieure de la membrane de la pellicule, la pression de la surface du cadre sur la surface inférieure de la membrane de la pellicule et la polymérisation de la membrane montée sur le cadre pour polymériser l'émulsion adhésive.

9. Procédé selon la Revendication 8, comprenant en outre l'étape consistant à laisser la membrane montée sur le cadre pendant une durée prédéterminée avant de réaliser l'étape de polymérisation.

10. Système de pellicule pour la photolithographie, ledit système comprenant un cadre de pellicule avec une surface supérieure et une membrane de pellicule avec une surface inférieure comprenant une zone externe, la membrane étant positionnable au-dessus du cadre de telle sorte que la zone externe puisse entrer en contact avec la surface supérieure du cadre, une émulsion adhésive selon l'une quelconque des Revendications 1 à 7 étant intercalée entre la zone externe de la membrane et la surface supérieure du cadre, et cette émulsion adhésive étant polymérisable en dernier lieu pour fixer la zone externe de la membrane à la surface supérieure du cadre.
